Europäisches Patentamt

(19) European Patent Office

Office européen des brevets

(11) Publication number: **0 168 165**
**A1**

# (12) EUROPEAN PATENT APPLICATION

(21) Application number: **85304029.3**

(22) Date of filing: **06.06.85**

(51) Int. Cl.⁴: **H 01 S 3/02**
**G 02 B 1/10**

(30) Priority: **06.06.84 GB 8414454**

(43) Date of publication of application:
**15.01.86 Bulletin 86/3**

(84) Designated Contracting States:
**AT BE CH DE FR GB IT LI LU NL SE**

(71) Applicant: **BRITISH TELECOMMUNICATIONS plc**
**British Telecom Centre 81 Newgate Street**
**London EC1A 7AJ(GB)**

(72) Inventor: **Devlin, William John**
**15 Rowanhayes Close**
**Ipswich IP2 9SX Suffolk(GB)**

(74) Representative: **Leng, Francis Edward et al,**
**British Telecom Intellectual Property Unit Room 1304**
**151 Gower Street**
**London WC1E 6BA(GB)**

(54) **Opto-electronic and electro-optic devices.**

(57) An opto-electronic or electro-optic device such as a semi-conductor laser having one or both reflective facets carrying an anti-reflection coating being an oxide of Y, Nd, La or preferably Gd.

EP 0 168 165 A1

./...

Croydon Printing Company Ltd.

## OPTO-ELECTRONIC AND ELECTRO-OPTIC DEVICES

### BT PATENT CASE A23120 (0131P)

This invention relates to opto-electronic and electro-optic devices, in particular semi-conductor lasers, having a reflective facet carrying an anti-reflection coating.

Semi-conducting lasers are one example of devices which can emit light through a planar facet which usually constitutes a solid/gas interface. There is inherently a degree of facet reflectivity when the refractive index of the material of the device is above unity. The nominal value is about $30^{\circ}/o$ for, say, Fabry-Perot semi-conductor lasers of conventional composition, i.e. with an equivalent refractive index of about 3.3. For certain uses, it may be desirable to decrease this reflectivity.

Ettenberg et al., IEEE J Quantum Elec. QE-17(11) (November 1981) 2211-2214 describe how the reflectivity of a mode-stabilised constricted double heterojunction laser can be altered by modifying the facet reflectivity. One of the two facets was coated, and the coating reflectivity ($R_c$) was determined by measuring the power outputs from the coated and uncoated facets ($P_c$ and $P_u$, respectively) on the basis of the expression

$$(P_c/P_u) = )R_u/R_c)^{1/2}(1-R_c)/(1-R_u)$$

and by assuming a value of the uncoated facet reflectivity ($R_u$). The materials used for coating were $Al_2O_3$ and Si in single or multiple thicknesses of $\lambda/4$. The minimum reported value for $R_c$ is $1.3^{\circ}/o$, based on $R_u$ as $32^{\circ}/o$, for a $\lambda/4$ $Al_2O_3$ anti-reflection coating.

Yamaguchi et al., Electron. Lett. 20(6) (1984) 233-235 describe a 1.3 μm InGaAsP/InP distributed-feedback double-channel planar buried heterostructure laser diode having one facet coated with a SiN (n = 1.85) film about λ/4 thick. It is stated that "the coated facet reflectivity was reproducibly reduced to less than 2°/o, with ~ 1900 Angstrom-thick SiN film". A theoretical curve is drawn suggesting that the reflectivity may approach zero at a certain film thickness.

The use of a SiN anti-reflection coating is also disclosed by Kaminow et al in the CLEO 83 (Baltimore) conference papers (their paper THA3). An anti-reflective coating having a reflectivity of about $2 \times 10^{-4}$ is disclosed, obtained by sputtering $Si_3N_4$ at 7.5 nm/min.

The coating of a laser facet with a silicon oxide has been proposed, the intention being that a SiO coating should be obtained by evaporation, to a given refractive index value, but the uncertain chemical nature of the coating which is produced suggests that the process may not be reproducible.

The use of $Sc_2O_3$ in an anti-reflection coating for semi-conductors is proposed in advertising literature produced by Cerac Inc., but no further details are given. $Sc_2O_3$ is toxic and rare.

IEEE Journal of Quantum Electronics, Vol.QE-19, No.3 for March 1984 at page 434 discloses the use of $ZrO_2$ as an anti-reflection coating and it indicates that reflectivity per facet was reduced to less than 0.5°/o from 810 to 840 nm. An earlier edition of the same journal, QE13 for July 1977, at page 529 discloses $CeO_2$ as an anti-reflection coating. The refractive index is given as about 1.7.

According to the present invention, an opto-electronic or electro-optic device having a reflective facet carrying a metal oxide anti-reflection coating (which facet) has a reflectivity of no more than $1^0/o$, characterised in the said metal is selected from Y, Gd, Nd and La. We have found that the sesquioxide $Gd_2O_3$ gives good results (although deposited coatings may not correspond to exact chemical formulae, e.g. they may contain a mixture of different oxides). By careful control of conditions, the reflectivity value may be no more than $0.1^0/o$ and can be no more than $0.01^0/o$.

The invention is of particular applicability to semi-conductor devices, of the type which already have a very high output but where substantially $100^0/o$ output is desirable. This is particularly the case for semi-conductor lasers when used as light amplifiers, but the invention is also applicable to other devices, e.g. light-emitting diodes, optical waveguides and optical fibres, although it is difficult to make much improvement in the last case, owing to the inherently low refractive index of most optical fibres. It is generally the case that the invention is of value where the material of the device has a high refractive index, e.g. above 2.5, and a coating material can be chosen which has a lower value, but greater than unity.

Devices of the invention can be produced by vapour-deposition, under vacuum, of the metal oxide onto one or both facets of a device such as a semi-conductor laser, to a thickness slightly greater than λ/4. The use of such a thickness is based on the realisation that not all light emitted from the device through a facet may be orthogonal to the plane of the facet, and that the reflectivity can be minimised by allowing for the diffracted light.

In producing a device of the invention having a single coated facet, optimum results may be achieved by monitoring the power output of the coated facet, and terminating the coating procedure when said power output reaches a maximum.

Conventional techniques often employ indirect monitoring to ascertain the thickness of the coating. These indirect techniques utilise an independent device, e.g. an oscillating quartz crystal, present at the time of coating. It is assumed that coatings form at the same rate on the monitor and all opto-electronic devices simultaneously present. Thus when the target thickness has been reached on the monitor the coating process is terminated. It is necessary to calibrate the indirect monitor and this is conveniently done by checking against the power output as described above.

The ratio of the power outputs from a coated and an uncoated facet can of course only be determined when one facet is coated. The given low reflectivity essential to the invention may alternatively be expressed in terms of the fact (since there is equivalence with respect to an uncoated device having a typical $R_u$ value of 25 to 35$^o$/o) that $P_c/P_u$ should be at least 8, preferably at least 25, and more preferably at least 80.

The refractive index of the coating, which is affected by its physical state, is also important. Particularly for semi-conductor lasers, the preferred refractive index is from 1.7 to 1.95, and more preferably from 1.8 to 1.85.

The oxides described above generally have a high melting point, often above 2000C. They may be volatilised by electron-stimulated heating under vacuum, for deposition on a device to be coated in accordance with the invention. It may sometimes be the case that a mixture of materials can be beneficially used, particularly if the coating conditions are controlled to allow "fine tuning" of the nature of the coating. In certain circumstances, the formula of a vapour-deposited material such as a metal oxide may not be exactly that of the material which is volatilised, owing to partial loss of oxygen from the oxide structure; it may then be necessary to include a small partial pressure of oxygen in the atmosphere in which the process is conducted.

A device of the invention may comprise a plurality of coatings on a facet, of alternating relatively high and relatively low refractive index (in either order), to minimise the reflectivity at that facet. This is conventional. The production method which is described is easily applicable to the control of the number and thicknesses of coatings.

Devices of the invention having one coated facet may be used in an external cavity device. A device of the invention having two coated facets may be used in an amplifier, e.g. for the amplification of optical signals which may have been attenuated during transmission along an optical fibre.

The following Example illustrates the invention.

EXAMPLE

The laser to be facet coated is mounted in a vacuum system on a temperature controlled stage, with the intended facet towards an electron beam evaporation source. Dielectric material ($Nd_2O_3$, $Y_2O_3$, $La_2O_3$ or $Gd_2O_3$) is placed in the source hearth, and the system evacuated to $10^{-6}$ torr (133 $\mu$Pa).

Electron bombardment causes the source material to evaporate and the vapour so produced condenses on the intended facet to produce the coating.

It is convenient to detect the end-point of the process by exiting the laser during coating and monitoring the intensity of the radiation emitted via the coating as it is formed. There is an optimum thickness of coating and the amount of radiation passing through the coating is a maximum at this thickness. Detection of this maximum is a good way of locating the end-point of the coating process.

In many cases the laser has two facets and radiation exits via both of them but, at constant excitation, the total emission of the two facets is constant. Thus if more radiation exits via one facet less leaves via the other and the maximum corresponds to the minimum at the other. Where the laser has two facets it is usual to coat both but in two separate processes. Thus in any one process there is the desired facet to which the coating is applied and the passive facet which, although it may be coated previously or later, is unaffected by the current process. We recommend that the monitoring be carried out at the passive facet, i.e. the end-point is taken as minimum intensity via the passive facet.

There are two reasons why we prefer to utilise the passive facet for the monitoring. The first reason is that it is easier to configure the equipment because a sensor positioned to receive illumination from the desired facet may hinder the access of vapour to form the coating. Positioning the sensor at the passive facet circumvents problems of this nature. The second reason is that the minimum at the passive facet is sharper than the maximum at the desired facet. (It is convenient to continue coating slightly past the perfect end-point by terminating as soon as it is noticed that the intensity at the passive facet has started to increase. This establishes that the end-point has been reached.)

During the process the monitored intensity changes over a large range which is beyond the capacity of the monitor. This difficulty can be overcome by increasing the exitation current to compensate. A series of stepwise increases is preferred.

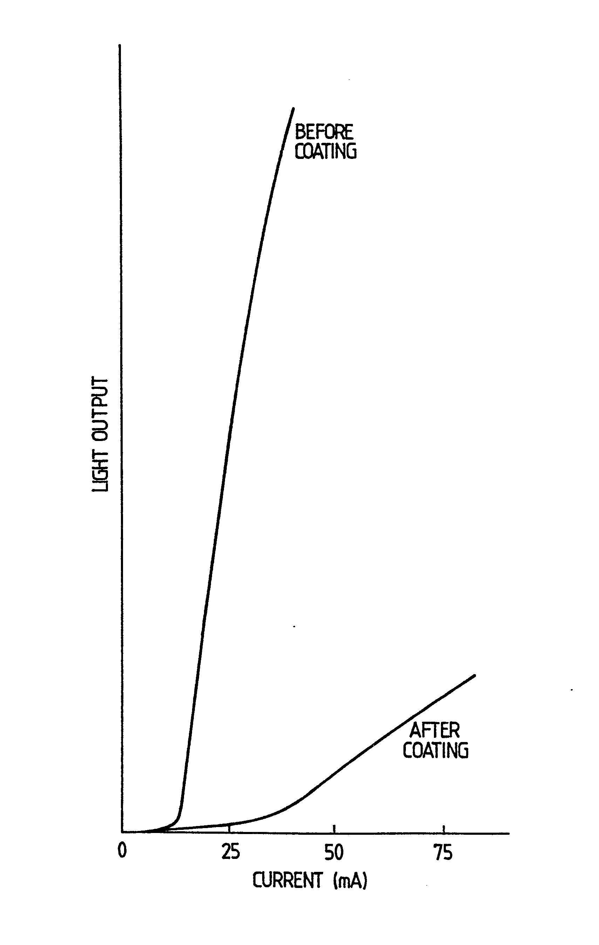

The performance of a laser and the effect of coating is illustrated in the Figure which shows two curves, i.e. "before coating" and "after coating" drawn on common axes. Each of the two curves comprises two straight line segments. The "spontaneous" segment corresponds to unstimulated operation giving a low light output which increases only slowly with excitation current. The "stimulated" segment, which relates to laser activity, indicates that light output increases rapidly with excitation current and that high light outputs can be obtained. There is a curved intermediate portion connecting the two linear segments.

The laser threshold is defined as the excitation current corresponding to the point where the extrapolations of the spontaneous and stimulated segments intersect. Thus the "before coating" curve has a threshold of (about) 12mA and "after coating" curve about 37mA. As well as increasing the threshold the coating reduces the slope of the stimulated segment.

Four different coatings were applied to four similar indium-gallium arsenide-phosphide lasers by the technique identified above. That is, the specified oxide was evaporated onto the intended facet by electron beam evaporation and the end point giving the optimum thickness was determined by the minimum intensity at the passive facet. The results of these coatings are given in Table I.

## TABLE I

Coating

| chemical type | $Gd_2O_3$ | $Y_2O_3$ | $Nd_2O_3$ | $La_2O_3$ |
|---|---|---|---|---|
| thickness (μm) | 0.22 | 0.22 | 0.22 | 0.22 |
| refractive index | 1.7 | 1.79 | * | 1.73 |
| at μm wavelength | 0.632 | 0.565 | | 0.56 |

Facet reflectivity

| before coating | 0.3 | 0.3 | 0.3 | 0.3 |
|---|---|---|---|---|
| after coating | <0.01 | <0.01 | <0.01 | <0.01 |

Laser Threshold (m/A)

| before coating | 18 | 11.5 | 12.5 | 10.9 |
|---|---|---|---|---|
| after coating | 51 | 22.3 | 14 | 32.3 |

(*indicates that this result is not available.)

Table I illustrates that oxides of the metals Gd, Y, Nd and La increase the laser threshold and this makes the device more suitable for use as an amplifier.

CLAIMS

1. An opto-electronic or electro-optic device having a reflective facet carrying a metal oxide anti-reflection coating, which facet has a reflectivity of no more than $1^o/o$, characterised that said metal is selected from Y, Gd, Nd and La.

2. A device according to Claim 1, wherein the metal is Gd.

3. A device according to Claim 1 or Claim 2, in which the reflectivity is no more than $0.1^o/o$ at the coated facet.

4. A device according to any preceding claim, in which the coating has a refractive index of from 1.7 to 1.95.

5. A semi-conductor device according to any preceding claim

6. A laser device according to any preceding claim.

7. An external cavity device including a device according to any preceding claim, having only one coated facet.

8. An amplifier including a device according to any of Claims 1 to 7, having two coated facets.

European Patent
Office

**EUROPEAN SEARCH REPORT**

0168165

Application number

EP 85 30 4029

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | APPLIED OPTICS, vol. 12, no. 2, February 1973, pages 394-397, New York, US; W. HEITMANN: "Reactively evaporated films of scandia and yttria" * Abstract * | 1,4-8 | H 01 S 3/02 G 02 B 1/10 |
| D,A | IEEE JOURNAL OF QUANTUM ELECTRONICS, vol. QE-19, no. 3, March 1983, pages 433-435, IEEE, New York, US; R.H. REDIKER et al.: "External cavity controlled operation of a semiconductor diode gain element in series with an optical fiber" * Page 434, column 1, lines 8-15 * | 1,5-8 | |
| D,A | IEEE JOURNAL OF QUANTUM ELECTORNICS, vol. QE-13, no. 7, July 1977, pages 525-531, IEEE, New York, US; K. KAZUHIRO et al.: "Near-infrared high-power LED's with Gal-xAlxAs epitaxially grown junctions" * Page 529, column 1, lines 4-8 *      -/- | 1,4-8 | **TECHNICAL FIELDS SEARCHED (Int. Cl. 4)** H 01 S H 01 L G 02 B |

The present search report has been drawn up for all claims

| Place of search | Date of completion of the search | Examiner |
|---|---|---|
| THE HAGUE | 13-09-1985 | GALANTI M. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO Form 1503 03 82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl.4) |
|---|---|---|---|
| D,A | IEEE JOURNAL OF QUANTUM ELECTRONICS, vol. QE-17, no. 11, November 1981, pages 221-2214, IEEE, New York, US; M. ETTENBERG et al.: "The effect of facet mirror reflectivity on the spectrum of single-mode CW constricted double-heterojunction diode lasers" * Page 2211, column 2, lines 14,15 * | 1,5-8 | |
| A | APPLIED PHYSICS LETTERS, vol. 44, no. 5, 1st March 1984, pages 481-483, American Institute of Physics, London, GB; G. PAO-LO LIU et al.: "Measurements of intensity fluctuations of an InGaAsP external cavity laser" * Page 481, column 1, lines 30-32,37-40 * | 1,3 | |

TECHNICAL FIELDS
SEARCHED (Int. Cl.4)

The present search report has been drawn up for all claims

| Place of search | Date of completion of the search | Examiner |
|---|---|---|
| THE HAGUE | 13-09-1985 | GALANTI M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82